# EUROPÄISCHE PATENTSCHRIFT

(11) **EP 1 289 011 B1**
(45) Veröffentlichungstag und Bekanntmachung des Hinweises auf die Patenterteilung: **28.11.2007**
(21) Anmeldenummer: 02016073.5
(22) Anmeldetag: 19.07.2002
(51) Int. Cl.: H01L 23/36, H05K 7/20, H05K 5/00

(54) **Schalt- oder Steuergerät**
Switching or control apparatus
Appareil de commutation ou de contrôle

(30) Priorität: 25.08.2001 DE 10141697
(43) Veröffentlichungstag der Anmeldung: 05.03.2003
(73) Patentinhaber: ROBERT BOSCH GMBH, 70442 Stuttgart (DE)
(72) Erfinder: Beckenbauer, Dietrich, 70499 Stuttgart (DE); Mayer, Frank, 71640 Ludwigsburg (DE); Schiefer, Peter, 74199 Unterheinriet (DE)

(56) Entgegenhaltungen:
- EP-A- 0 728 405
- EP-A- 0 883 332
- DE-A- 19 506 664

## Beschreibung

### Stand der Technik

Die Erfindung betrifft ein Schalt- oder Steuergerät nach dem Oberbegriff des Anspruchs 1, wie es aus der EP 0 883 332 A2, der DE 195 06 664 A1 oder der EP 0 728 405 B1 bekannt ist. Bei dem bekannten Gerät ist ein elektrisches, wärmeabgebendes Bauelement über ein integriertes Metallteil auf einer Kupferschicht auf einer Leiterplatte befestigt. Die Kupferschicht reicht vom Bauelement bis in einen randseitigen Bereich der Leiterplatte hinein. Dort ist die Leiterplatte zwischen den umlaufenden Flanschbereichen der beiden Gehäusehälften des Gehäuses angeordnet, wobei durch eine ballige Form der mit der Kupferschicht in Kontakt stehenden Gehäusehälfte ein Pressverband herstellbar ist, der eine thermische Ankopplung der Kupferschicht an das Gehäuse ohne zusätzliche Lötung, Klebung oder ähnlichem ermöglicht.

Weiterhin ist in der EP 0 728 405 B1 auch erwähnt, die Kupferschicht auf der Seite des Bauelements mittels Durchkontaktierungen mit einer zusätzlichen Kupferschicht auf der anderen Leiterplattenseite zu verbinden, so dass der Wärmefluss verbessert ist. Jedoch findet sowohl bei einer, als auch bei zwei Kupferschichten auf der Leiterplatte stets insbesondere ein Wärmetransport beziehungsweise eine Wärmeleitung längs der Leiterplatte vom Ort des Bauelements hin zu dem Leiterplattenrand im Gehäuseinneren statt, was aufgrund der Wärmeabstrahlung der Kupferschicht zu einer zusätzlichen und unerwünschten Temperaturerhöhung im Gehäuseinneren führt.

### Vorteile der Erfindung

Das erfindungsgemäße Schalt- oder Steuergerät mit den kennzeichnenden Merkmalen des Anspruchs 1 hat demgegenüber den Vorteil, dass die Verlustwärme unmittelbar auf dem kürzesten Weg, das heißt senkrecht zur Leiterplattenebene, vom wärmeabgebenden Bauelement an das Gehäuse, welches eine entsprechend ausgebildete Kühlfläche aufweist, abgeleitet wird. Dadurch wird eine Minimierung der Wärmeabstrahlung im Gehäuseinneren erreicht. Gleichzeitig lässt sich das erfindungsgemäße Schalt- oder Steuergerät aufgrund der aus der EP 0 728 405 B1 bekannten Klemmtechnologie besonders einfach und somit kostengünstig montieren und herstellen.

Weitere vorteilhafte Weiterbildungen des erfindungsgemäßen Schalt- oder Steuergeräts sind in den Unteransprüchen angegeben.

### Zeichnung

Zwei Ausführungsbeispiele der Erfindung sind in der Zeichnung dargestellt und werden nachfolgend näher erläutert. Es zeigen:
Figur 1 ein erstes erfindungsgemäßes Schalt- oder Steuergerät in einer vereinfachten perspektivischen Darstellung,
Figur 2 das erste Schalt- oder Steuergerät nach Figur 1 in einer vereinfachten Seitenansicht,
Figur 3 ein zweites erfindungsgemäßes Schalt- oder Steuergerät in einer vereinfachten perspektivischen Darstellung und
Figur 4 das zweite Schalt- oder Steuergerät nach Figur 3 in einer vereinfachten Seitenteilansicht.

### Beschreibung der Ausführungsbeispiele

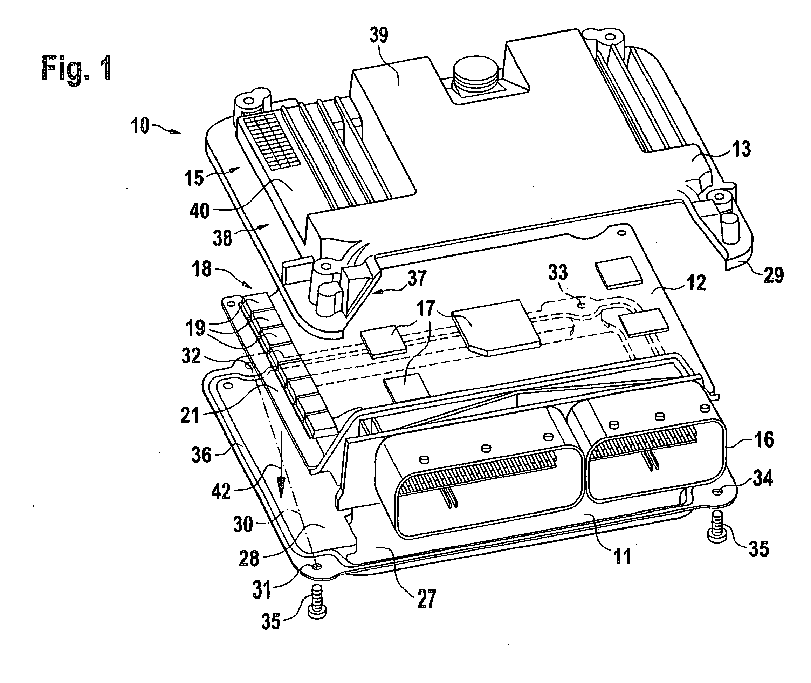

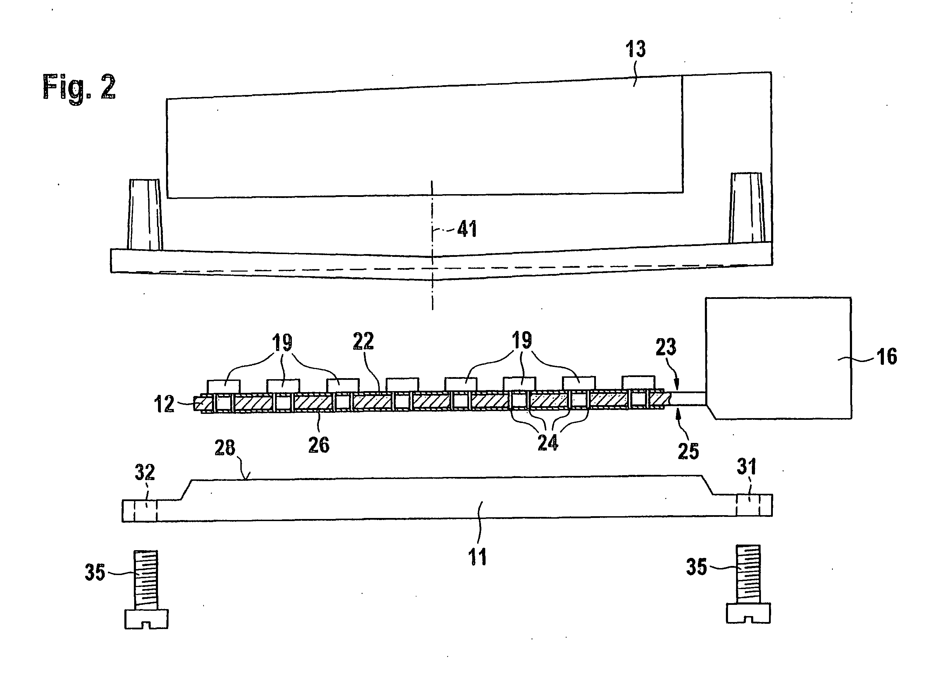

In den Figuren 1 und 2 ist ein erstes Schalt- oder Steuergerät 10 dargestellt, wie es vorzugsweise in einem Kraftfahrzeug verwendet wird. Das Schalt- oder Steuergerät 10 besteht im wesentlichen aus einem Boden 11, einer Leiterplatte 12 und einem Deckel 13. Der Boden 11 und der Deckel 13 bilden zusammen ein Gehäuse 15 aus, das die Leiterplatte 12 mit Ausnahme im Bereich eines mit der Leiterplatte 12 verbundenen Steckerkörpers 16 umschließt.

Auf der Leiterplatte 12 sind mehrere erste elektrische Bauelemente 17 angeordnet. Weiterhin sind in einem Randbereich 18 der im wesentlichen rechteckigen Leiterplatte 12 mehrere zweite elektrische Bauelemente 19 angeordnet, welche beim Betrieb des Schalt- oder Steuergeräts 10 Wärme erzeugen, die zur Vermeidung von Betriebsstörungen aus dem Schalt- oder Steuergerät 10 abgeleitet werden muss. Die Bauelemente 17 und 19 sind Bestandteil einer auf der Leiterplatte 12 realisierten elektronischen Schaltung.

Die Anordnung der zweiten, wärmeerzeugenden Bauelemente 19 auf der Leiterplatte 12 ist derart, dass neben den zweiten Bauelementen 19 auf der dem Leiterplattenrand zugewandten Seite noch ein bauelementefreier Randstreifen 21 auf der Leiterplatte 12 ausgebildet ist. Die zweiten Bauelemente 19 sind beispielsweise mittels einer ersten Lotschicht 22 mit der Oberseite 23 der an dieser Stelle kupferkaschierten Leiterplatte 12 wärmeleitend verbunden. Die erste Lotschicht 22 ist über Durchkontaktierungen 24 mit einer an der Unterseite 25 der Leiterplatte 12 angeordneten zweiten Lotschicht 26 gekoppelt.

Der Boden 11 ist vorzugsweise als ein aus Blech gezogenes Stanzteil ausgebildet. Der Boden 11 weist im Bereich zumindest der ersten Bauelemente 17 einen abgesenkten Abschnitt 27 auf, so dass die Unterseite 25 der Leiterplatte 12 bei mit dem Boden 11 verbundener Leiterplatte 12 zur Leiterplatte 12 hin beabstandet ist. Im Bereich der zweiten, wärmeabgebenden Bauelemente 19 weist der Boden 11 hingegen einen gegenüber dem Abschnitt 27 erhöhten, ebenen, als Kühlfläche dienenden Abschnitt 28 auf, der bei der Montage der Leiterplatte 12 mit dem Boden 11 unmittelbar in Kontakt mit der Unterseite 25 der Leiterplatte 12 bringbar ist.

Im Boden 11 sind weiterhin im Bereich der Ecken des Schalt- oder Steuergeräts 10 Löcher 31 bis 34 ausgebildet, die mit entsprechenden Durchgangsbohrungen oder Aussparungen in der Leiterplatte 12 fluchten, und die der Verschraubung des Bodens 11 mit dem Deckel 13 mittels Schrauben 35 unter Zwischenlage der Leiterplatte 12 dienen. In der Figur 1 erkennt man ferner eine im Randbereich des Bodens 11 umlaufende, raupenförmig aufgebrachte Dichtmasse 36, die bei montierten Schalt- oder Steuergerät 10 der Abdichtung des Bodens 11 zum Deckel 13 beziehungsweise zum Steckerkörper 16 hin dient.

Wesentlich ist auch, dass die beiden Löcher 31, 32, die im Bereich der Schmalseite des Abschnitts 28 angeordnet sind, derart zueinander positioniert sind, dass eine strichpunktiert in der Figur 1 eingezeichnete Gerade 30 durch die beiden Löcher 31, 32 über den Abschnitt 28 derart verläuft, daß die Gerade 30 auch den Bereich der wärmeabgebenden Bauelemente 19 schneidet.

Der haubenförmige Deckel 13 ist beispielsweise ebenfalls aus Blech in einem Umformverfahren hergestellt. Der Deckel 13 hat auf der dem Steckerkörper 16 zugewandten Seite einen Ausschnitt 37. Außerhalb des Ausschnitts 37 verläuft am Dekkel 13 randseitig ein flanschförmig umlaufender, ebener Verbindungsbereich 38, der mit dem entsprechenden Bereich des Bodens 11 und der Dichtmasse 36 in Kontakt bringbar ist. Ferner schließt sich an den Verbindungsbereich 38 noch ein die Leiterplatte 12 und den Boden 11 überkragender Rand 29 an, der bei montiertem Schalt- oder Steuergerät 10 die Stirnflächen der Leiterplatte 12 und des Bodens 11 abdeckt. Zumindest in den Bereichen, in denen die Bauelemente 17, 19 auf der Leiterplatte 12 angeordnet sind, weist der Deckel 13 entsprechende Ausbuchtungen 39, 40 auf, so daß die Bauelemente 17, 19 zum Deckel 13 hin beabstandet sind.

Wesentlich ist, dass der Verbindungsbereich 38 des Deckels 13 im Bereich des Randstreifens 21 der Leiterplatte 12 derart ausgebildet ist, dass bei montierten Schalt- oder Steuergerät 10 im Bereich des Randstreifens 21 und des Abschnitts 28 eine sandwichartige Ausbildung erzeugt ist, bei der der Randstreifen 21 der Leiterplatte 12 und der Abschnitt 28 des Bodens 11 sowie der Verbindungsbereich 38 des Deckels 13 unmittelbar aufeinanderliegen, so dass auch die Lotschicht 26 auf der Unterseite 25 der Leiterplatte 12 im Bereich der wärmeabgebenden Bauelemente 19 mit dem entsprechenden Bereich des Abschnitts 28 des Bodens 11 wärmeleitend gekoppelt ist.

Um diese Verbindung zwischen den Bauteilen ohne zusätzlichen Einsatz von Wärmeleitkleber oder ähnlichem sicher zu erreichen, obwohl auch dies vorgesehen sein kann, ist der Verbindungsbereich 38 des Deckels 13 im Bereich des Randbereichs 21 der Leiterplatte 12 ballig ausgebildet, wie am besten aus der Figur 2 ersichtlich ist. Entsprechend der EP 0 728 405 B1 weist die Oberflächenform im Bereich der Mittelachse 41 des Deckels 13 in unmontiertem Zustand des Gehäuses 15 eine Entfernung von ca. 0,2 bis 0,4 mm gegenüber den Eckbereichen auf. Nach der Montage des Deckels 13 auf dem Randstreifen 21 der Leiterplatte 12 und der Leiterplatte 12 auf dem Abschnitt 28 des Bodens 11 schmiegt sich der Verbindungsbereich 38 des Deckels 11 aufgrund der Schraubkräfte der Schrauben 35 dicht an den Randstreifen 21 der Leiterplatte 12 an, so dass der dabei entstehende Anpressdruck die Lotschicht 26 dauerhaft gegen den Abschnitt 28 des Bodens 11 drückt.

Ergänzend wird an dieser Stelle erwähnt, daß es für den Wärmeübergang wesentlich ist, daß eine Anlage zwischen dem Abschnitt 28 des Bodens 11 und dem Bereich der Leiterplatte 12 erfolgt, auf dem die wärmeabgebenden Bauelemente 19 angeordnet sind. In diesem Bereich liegt zwar der Verbindungsbereich 38 des Deckels 13 nicht auf der Leiterplatte 12 auf, jedoch wird die Kontaktkraft infolge der Steifigkeit der Leiterplatte 12 vom Randstreifen 21 der Leiterplatte 12 in den Bereich der Leiterplatte 12 übertragen, auf dem sich die Bauelemente 19 befinden. Dies wird zusätzlich durch die versetzte Anordnung der Löcher 31, 32 verstärkt, da die aus den Schrauben 35 resultierende Summenschraubkraft auf der bereits erwähnten Geraden 30 durch die Löcher 31, 32 liegt, die den Bereich der Bauelemente 19 schneidet.

Ferner ist beim beschriebenen Ausführungsbeispiel die der Leiterplatte 12 zugewandte Unterseite des Deckels 13 ballig ausgebildet, der Boden 11 jedoch eben. Es ist zwar statt dessen oder zusätzlich auch denkbar, die der Leiterplatte 12 zugewandte Seite des Bodens 11 ballig auszubilden. Vorteilhaft ist jedoch die beschriebene Balligkeit des Deckels 13, da dieser alleine schon aufgrund seiner Formgebung üblicherweise eine höhere Steifigkeit aufweist und somit höhere Presskräfte auf die Leiterplatte 12 übertragbar sind.

Beim Betrieb des Schalt- oder Steuergeräts 10, bei dem die zweiten Bauelemente 19 Verlustwärme erzeugen, wird diese Verlustwärme von den zweiten Bauelementen 19 über die Lotschicht 22 und die Durchkontaktierungen 24 auf die Lotschicht 26 auf der Unterseite 25 der Leiterplatte 12 übertragen. Von dort gelangt die Verlustwärme unmittelbar durch den wärmeleitenden Kontakt in den als Kühlfläche wirkenden Abschnitt 28 des Bodens 11. Der Wärmetransport erfolgt somit senkrecht zur Leiterplattenebene.

Je nach Höhe der Verlustleistung des bzw. der Bauelemente 19 ist es gegebenenfalls erforderlich, die in den Abschnitt 28 des Bodens 11 übertragene Wärme mittels bekannter Maßnahmen beispielsweise an die Karosserie des Kraftfahrzeugs abzuleiten.

Wesentlich bezüglich des Wärmetransports von den zweiten Bauelementen 19 an den Boden 11 beziehungsweise das Gehäuse 15 ist, dass der Wärmetransport innerhalb des Schalt- oder Steuergeräts 10 ausschließlich senkrecht zur Erstreckung der Leiterplatte 12, das heißt in Richtung des Pfeils 42, und somit auf dem kürzesten Weg erfolgt. Dadurch wird die Wärmeabstrahlung insbesondere von den dem Wärmetransport dienenden Lotschichten 22, 26 in das Gehäuseinnere minimiert.

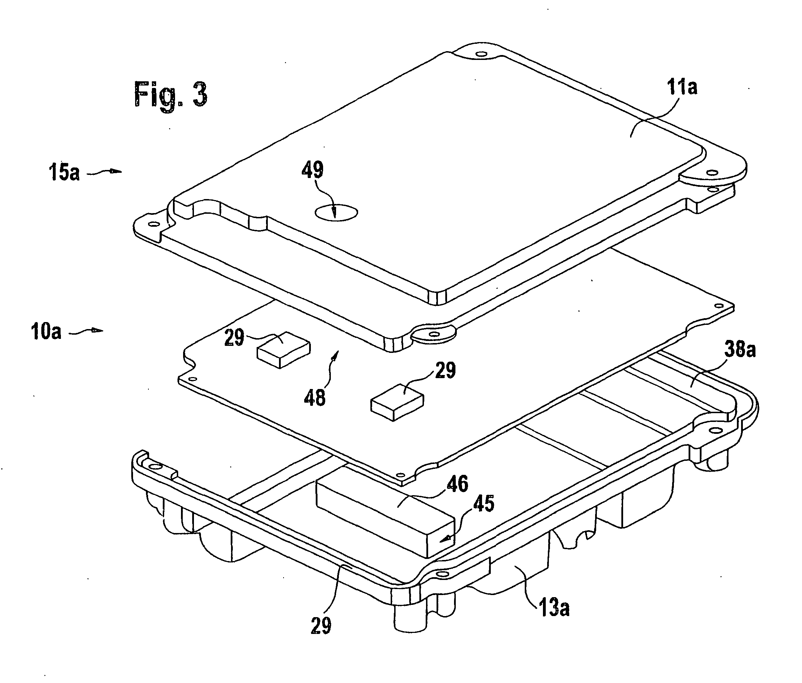

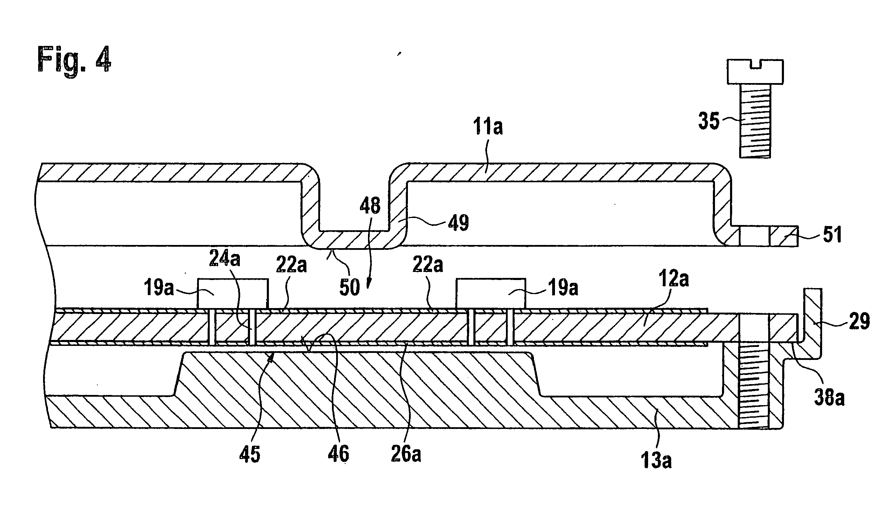

Die Figuren 3 und 4 zeigen ein zweites Ausführungsbeispiel der Erfindung. Bei dem dort dargestellten Schalt- oder Steuergerat 10a, bei dem im Vergleich zum Schalt- oder Steuergerät 10 der Boden 11a und der Deckel 13a zeichnerisch auf dem Kopf angeordnet sind, weist der Deckel 13a in einem mittleren Bereich, das heißt in einem von dem Verbindungsbereich 38a beabstandeten Bereich eine durch einen Umformprozeß hergestellte Einformung 45 auf, deren der Leiterplatte 12a zugewandte ebene Oberseite 46 als Kühlfläche wirkt und in einer Ebene angeordnet ist, in der die zugewandte Seite der Leiterplatte 12a in wärmeleitendem Kontakt mit der Oberseite 46 ist, das heißt in Höhe des Verbindungsbereichs 38a liegt (Figur 4). Auf der der Oberseite 46 der Einformung 45 gegenüberliegenden Seite der Leiterplatte 12a sind die zu kühlenden Bauelemente 19a angeordnet. Auch die Bauelemente 19a sind mittels einer Lotschicht 22a mit der Leiterplatte 12a wärmeleitend verbunden. Die Lotschicht 22a ist mittels Durchkontaktierungen 24a mit einer weiteren Lotschicht 26a auf der den Bauelementen 19a gegenüberliegenden Seite der Leiterplatte 12a verbunden. Wesentlich ist, dass die Oberseite 46 der Einformung 45 eine derartige Größe aufweist, dass sie die zu kühlenden Bauelemente 19a bzw. die Lotschicht 26a überdeckt.

Zwischen den beiden im Ausführungsbeispiel dargestellten zu kühlenden Bauelementen 19a ist auf der Leiterplatte 12a ein Zwischen- beziehungsweise Freiraum 48 ausgebildet. In diesen Freiraum 48 ragt bei montiertem Schalt- oder Steuergerät 10a ein domähnlicher Fortsatz 49 hinein, der im Boden 11a mittels einer im Umformverfahren hergestellten Vertiefung gebildet ist.

Wie insbesondere Figur 4 bei unmontiertem Schalt- oder Steuergerät 10a zeigt, weist die der Leiterplatte 12a zugewandte Kontaktfläche 50 des Fortsatzes 49 einen geringeren Abstand zur Leiterplatte 12a auf als der umlaufende Randbereich 51 des Bodens 11a. Dies hat zur Folge, dass sich der Boden 11a bei der Montage des Schalt- oder Steuergeräts 10a verwölbt, wobei die Kontaktfläche 50 des Fortsatzes 49 gegen die Leiterplatte 12a gedrückt wird und diese mit einer Anpresskraft gegen die Oberseite 46 der Einformung 45 drückt.

Um eine Wärmeübertragung von der Lotschicht 22a in horizontaler Richtung des Fortsatzes 49 auszuschließen bzw. zu vermeiden, kann die Lotschicht 22a, wie dargestellt, im Bereich des Freiraums 48 ausgespart sein.

Die Anpresskraft des Fortsatzes 49 sorgt für einen sicheren, dauerhaften und wärmeleitenden Kontakt zwischen der Oberseite 46 der Einformung 45 und der Lotschicht 26a der Leiterplatte 12a.

Auch bei dem zweiten Ausführungsbeispiel ist somit eine Wärmeübertragung von den Bauelementen 19a an den als Kühlfläche wirkenden Deckel 13a des Schalt- oder Steuergeräts 10a senkrecht zur Leiterplattenebene realisiert, so dass die Wärmeabstrahlung im Gehäuseinneren minimiert ist.

Zusätzlich wird erwähnt, daß es bei dem zweiten Ausführungsbeispiel auch denkbar ist, die Oberseite 46 der Einformung 45 etwas über das Niveau des Verbindungsbereichs 38a anzuordnen, und statt dessen die Kontaktfläche 50 in Höhe des Randbereichs 51 des Bodens 11a zu legen. Weiterhin können die Oberseite 46 der Einformung 45 bzw. die Kontaktfläche 50 anstatt eben entsprechend dem ersten Ausführungsbeispiel auch ballig ausgebildet sein.

Auch kann zur Verbesserung der Wärmeübertragung zusätzlich ein Wärmeleitkleber zwischen der Lotschicht 26 bzw. 26a und dem Abschnitt 28 bzw. der Oberseite 46 des Abschnitts 45 vorgesehen sein.

## Patentansprüche

1. Schalt- oder Steuergerät (10; 10a), mit wenigstens einer eine elektronische Schaltung tragenden Leiterplatte (12; 12a), wobei die elektronische Schaltung wenigstens ein zu kühlendes Bauelement (19; 19a) umfasst, das über eine Auflagefläche (22; 22a) wärmeleitend mit der Leiterplatte (12; 12a) verbunden ist, mit einem einen Boden (11; 11a) und einen Deckel (13; 13a) aufweisenden Gehäuse (15; 15a), das die wenigstens eine Leiterplatte (12; 12a) randseitig sandwichartig umschließt, wobei die Verlustwärme des wenigstens einen zu kühlenden Bauelements (19; 19a) über einen als Kühlfläche dienenden Teilbereich (28; 45) des Bodens (11) oder des Deckels (13a) abführbar ist, und wobei die thermische Kopplung der Leiterplatte (12; 12a) zu dem Teilbereich (28; 45) mittels eines Pressverbands zwischen dem Boden (11; 11a), der Leiterplatte (12; 12a) und dem Deckel (13; 13a) ausgebildet ist, wobei die Auflagefläche (22; 22a) über mindestens eine Durchkontaktierung (24; 24a) mit der dem wenigstens einen zu kühlenden Bauelement (19; 19a) gegenüberliegenden Seite der Leiterplatte (12; 12a) verbunden ist, welche im Bereich der mindestens einen Durchkontaktierung (24; 24a) eine Wärmeübergangsfläche (26; 26a) aufweist und dass das wenigstens eine zu kühlende Bauelement (19; 19a) in Deckung mit dem Teilbereich (28; 45) angeordnet ist, so dass das Abführen der Verlustwärme des wenigstens einen zu kühlenden Bauelements (19; 19a) über die Auflagefläche (22; 22a), die mindestens eine Durchkontaktierung (24; 24a) und die Wärmeübergangsfläche (26; 26a) in den Teilbereich (28; 45) senkrecht zur Leiterplattenebene (Pfeil 42) erfolgt, **dadurch gekennzeichnet, dass** der Teilbereich (28;45) unmittelbar in Kontakt mit der Unterseite (25) oder der Oberseite (46) der Leiterplatte (12; 12a) ist.

2. Schalt- oder Steuergerät nach Anspruch 1, **dadurch gekennzeichnet, dass** der Teilbereich (28) in einem randseitigen Bereich des Bodens (11) ausgebildet ist und dass neben dem wenigstens einen zu kühlenden Bauelement (19) auf der dem randseitigen Bereich zugewandten Seite eine streifenförmige Zone (18) ausgebildet ist, die zwischen dem Boden (11) und dem Deckel (13) sandwichartig aufgenommen ist.

3. Schalt- oder Steuergerät nach Anspruch 2, **dadurch gekennzeichnet, daß** der Deckel (11) bei unmontiertem Gehäuse (15) im Bereich der streifenförmigen Zone (18) zur Bildung des Pressverbands ballig ausgebildet ist.

4. Schalt- oder Steuergerät nach Anspruch 3, **dadurch gekennzeichnet, daß** Deckel (13) eine höhere Steifigkeit aufweist als der Boden (11).

5. Schalt- oder Steuergerät nach einem der Ansprüche 2 bis 4, **dadurch gekennzeichnet, daß** in den Eckbereichen des Bodens (11) und des Deckels (13) zueinander fluchtende Bohrungen (31 bis 34) für Gehäuseschrauben (35) ausgebildet sind, wobei zwei Bohrungen (31, 32) in Bezug auf eine Schmalseite des Teilbereichs (28) versetzt zueinander angeordnet sind, so daß eine Verbindungsgerade (30) zwischen den beiden Bohrungen (31, 32) den Bereich der Auflagefläche (22) des wenigstens einen zu kühlenden Bauelements (19) schneidet.

6. Schalt- oder Steuergerät nach Anspruch 1, **dadurch gekennzeichnet, daß** auf der dem wenigstens einen zu kühlenden Bauelement (19a) zugewandten Seite der Leiterplatte (12a) in Deckung mit dem Teilbereich (45) eine bauelementfreie Zone (48) ausgebildet ist, in die ein Bereich (49) des Bodens (11a) hineinragt, wobei die der Zone (48) zugewandte Kontaktfläche (50) des Bereichs (49) einen geringeren Abstand zur Leiterplatte (12a) aufweist als der Randbereich (51) des Bodens (11a), der zur sandwichartigen Aufnahme der Leiterplatte (12a) im Gehäuse (15a) dient.

7. Schalt- oder Steuergerät nach Anspruch 6, **dadurch gekennzeichnet, daß** der im Deckel (13a) des Gehäuses (15a) ausgebildete Teilbereich (45) sich in einer Ebene mit dem Verbindungsbereich (38a) des Deckels (13a) befindet, so daß die Leiterplatte (12a) bei unmontiertem Gehäuse (15a) mit ihrer Wärmeübergangsfläche (26a) flächig auf dem Teilbereich (45) aufliegt.

8. Schalt- oder Steuergerät nach einem der Ansprüche 1 bis 7, **dadurch gekennzeichnet, daß** der Teilbereich (28; 45) durch ein spanloses Umformverfahren des Bodens (11) oder des Deckels (13a) gebildet ist.

9. Schalt- oder Steuergerät nach einem der Ansprüche 6 bis 8, **dadurch gekennzeichnet, daß** der in die Zone (48) der Leiterplatte (12a) hineinragende Bereich eine durch Umformen des Bodens (11a) gebildete Einformung (45) ist.

10. Schalt- oder Steuergerät nach einem der Ansprüche 1 bis 9, **dadurch gekennzeichnet, daß** zwischen dem als Kühlfläche dienenden Teilbereich (28; 45) und der Wärmeübergangsfläche (26; 26a) ein Wärmeleitkleber angeordnet ist.

## Claims

1. Switching or control apparatus (10; 10a) having at least one printed circuit board (12; 12a) which carries an electronic circuit, the electronic circuit comprising at least one component (19; 19a) which is to be cooled and is thermally conductively connected to the printed circuit board (12; 12a) by means of a bearing area (22; 22a), having a housing (15; 15a) which has a base (11; 11a) and a lid (13; 13a) and surrounds the edges of the at least one printed circuit board (12; 12a) like a sandwich, the heat loss of the at least one component (19; 19a) to be cooled being able to be dissipated via a partial region (28; 45) of the base (11) or of the lid (13a), said partial region being used as a cooling area, and the printed circuit board (12; 12a) being thermally coupled to the partial region (28; 45) by means of an interference fit between the base (11; 11a), the printed circuit board (12; 12a) and the lid (13; 13a), the bearing area (22; 22a) being connected, by means of at least one plated-through hole (24; 24a), to that side of the printed circuit board (12; 12a) which is opposite the at least one component (19; 19a) to be cooled and has a heat transfer area (26; 26a) in the region of the at least one plated-through hole (24; 24a), and the at least one component (19; 19a) to be cooled being arranged in such a manner that it coincides with the partial region (28; 45), with the result that the heat loss of the at least one component (19; 19a) to be cooled is dissipated into the partial region (28; 45) in a manner perpendicular to the plane of the printed circuit board (arrow 42) via the bearing area (22; 22a), the at least one plated-through hole (24; 24a) and the heat transfer area (26; 26a), **characterized in that** the partial region (28; 45) is in direct contact with the underside (25) or the top side (46) of the printed circuit board (12; 12a).

2. Switching or control apparatus according to Claim 1, **characterized in that** the partial region (28) is formed in an edge region of the base (11), and **in that** a strip-type zone (18) which is accommodated like a sandwich between the base (11) and the lid (13) is formed beside the at least one component (19) to be cooled on the side facing the edge region.

3. Switching or control apparatus according to Claim 2, **characterized in that**, when the housing (15) is not assembled, the lid (11) is of spherical design in the region of the strip-type zone (18) in order to form the interference fit.

4. Switching or control apparatus according to Claim 3, **characterized in that** the lid (13) has greater rigidity than the base (11).

5. Switching or control apparatus according to one of Claims 2 to 4, **characterized in that** aligned bores (31 to 34) for housing screws (35) are formed in the corner regions of the base (11) and of the lid (13), two bores (31, 32) being arranged such that they are offset with respect to one another in relation to a narrow side of the partial region (28), with the result that a connecting straight line (30) between the two bores (31, 32) intersects the region of the bearing area (22) of the at least one component (19) to be cooled.

6. Switching or control apparatus according to Claim 1, **characterized in that** a zone (48) which is free of components and into which a region (49) of the base (11a) projects is formed in such a manner that it coincides with the partial region (45) on that side of the printed circuit board (12a) which faces the at least one component (19a) to be cooled, that contact area (50) of the region (49) which faces the zone (48) being at a shorter distance from the printed circuit board (12a) than the edge region (51) of the base (11a) that is used to hold the printed circuit board (12a) in the housing (15a) like a sandwich.

7. Switching or control apparatus according to Claim 6, **characterized in that** the partial region (45) formed in the lid (13a) of the housing (15a) is situated on a plane with the connecting region (38a) of the lid (13a), with the result that, when the housing (15a) is not assembled, the heat transfer area (26a) of the printed circuit board (12a) rests on the partial region (45) in a two-dimensional manner.

8. Switching or control apparatus according to one of Claims 1 to 7, **characterized in that** the partial region (28; 45) is formed using a non-cutting shaping method for the base (11) or the lid (13a).

9. Switching or control apparatus according to one of Claims 6 to 8, **characterized in that** the region which projects into the zone (48) of the printed circuit board (12a) is a shaped recess (45) that is formed by shaping the base (11a).

10. Switching or control apparatus according to one of Claims 1 to 9, **characterized in that** a thermally conductive adhesive is arranged between the partial region (28; 45), which is used as a cooling area, and the heat transfer area (26; 26a).

## Revendications

1. Appareil de commande ou de commutation (10, 10a) ayant au moins une plaque de circuit (12, 12a) portant un circuit électronique,
le circuit électronique ayant au moins un composant à refroidir (19, 19a) relié par une surface d'appui (22, 22a) de façon thermoconductrice à la plaque de circuit (12, 12a), ayant un boîtier (15, 15a) muni d'un fond (11, 11a) et d'un couvercle (13, 13a), ce boîtier entourant en sandwich au moins le bord d'une plaque de circuit (12, 12a),
la chaleur dégagée par au moins un composant (19, 19a) à refroidir étant évacuée par une zone partielle (28, 45) du fond (11) ou du couvercle (13a) servant de surface de refroidissement et
le couplage thermique de la plaque de circuit (12, 12a) avec la zone partielle (28, 45) se fait par une liaison pressée entre le fond (11, 11a), la plaque de circuit (12, 12a) et le couvercle (13, 13a),
la surface d'appui (22, 22a) étant reliée à la face de la plaque de circuit (12, 12a) en regard d'au moins un composant (19, 19a) à refroidir, cette face ayant, au niveau d'au moins un contact traversant (24, 24a), une surface de conduction de chaleur (26, 26a) et
au moins un composant (19, 19a) à refroidir est installé en couverture de la zone partielle (28, 45) de façon que l'évacuation de la chaleur dégagée par au moins un composant (19, 19a) à refroidir se fait par la surface d'appui (22, 22a), par au moins un contact traversant (24, 24a) et la surface d'échange de chaleur (26, 26a) dans la zone partielle (28, 45) perpendiculaire au plan de la plaque de circuit (flèche 42),
**caractérisé en ce que**
la zone partielle (28, 45) est directement en contact avec la face inférieure (25) ou la face supérieure (46) de la plaque de circuit (12, 12a).

2. Appareil de commande ou de commutation selon la revendication 1,
**caractérisé en ce que**
la zone partielle (28) est réalisée dans la zone du côté du bord du fond (11) et
à côté d'au moins un composant à refroidir (19), sur la face tournée vers la zone du côté du bord, on a réalisé une zone en forme de bande (18) reçue en sandwich entre le fond (11) et le couvercle (13).

3. Appareil de commande ou de commutation selon la revendication 2,
**caractérisé en ce que**
lorsque le boîtier (15) n'est pas monté, le couvercle (11), a une forme bombée au niveau de la zone (18) en forme de bande pour former la liaison pressée.

4. Appareil de commande ou de commutation selon la revendication 3,
**caractérisé en ce que**
le couvercle (13) a une rigidité plus élevée que celle du fond (11).

5. Appareil de commande ou de commutation selon l'une des revendications 2 à 4,
**caractérisé en ce que**
les zones de coins du fond (11) et du couvercle (13), ont des perçages alignés (31-34) pour les vis (35) du boîtier,
deux perçages (31, 32) étant décalés l'un par rapport à l'autre par rapport au petit côté de la zone partielle (28) de façon qu'une droite (30) passant entre les deux perçages (31, 32) coupe la zone de la surface d'appui (22) d'au moins un composant (19) à refroidir.

6. Appareil de commande ou de commutation selon la revendication 1,
**caractérisé en ce que**
sur la face de la plaque de circuit (12) tournée vers au moins un composant à refroidir (19), en couverture de la zone partielle (45) on a réalisé une zone (48) sans composant dans laquelle pénètre une zone (49) du fond (11a),
la surface de contact (50) de la zone (49) tournée vers la zone (48) a une distance plus faible par rapport à la plaque de circuit (12a) que la zone de bord (51) du fond (11a) servant à recevoir en sandwich la plaque de circuit (12a) dans le boîtier (15a).

7. Appareil de commande ou de commutation selon la revendication 6,
**caractérisé en ce que**
la zone partielle (45) réalisée dans le couvercle (13a) du boîtier (15a) se trouve dans un plan avec la zone de liaison (38a) du couvercle (13a) de sorte que le boîtier (15a) n'étant pas monté, la plaque de circuit (12a) s'appuie par sa surface d'échange de chaleur (26a) à plat contre la zone partielle (45).

8. Appareil de commande ou de commutation selon l'une des revendications 1 à 7,
**caractérisé en ce que**
la zone partielle (28, 45) est réalisée par un procédé de transformation sans enlèvement de copeaux, du fond (11) ou du couvercle (13a).

9. Appareil de commande ou de commutation selon l'une des revendications 6 à 8,
**caractérisé en ce que**
la zone pénétrant dans la zone (48) de la plaque de circuit (12a) est une partie enfoncée (45) réalisée par transformation du fond (11a).

10. Appareil de commande ou de commutation selon l'une des revendications 1 à 9,
**caractérisé par**
un adhésif thermoconducteur entre la zone partielle (28, 45) servant de surface de refroidissement et la surface d'échange de chaleur (26, 26a).
